(19) **Europäisches Patentamt / European Patent Office / Office européen des brevets**

(11) **EP 1 993 122 A2**

(12) # EUROPEAN PATENT APPLICATION

(43) Date of publication:
**19.11.2008 Bulletin 2008/47**

(51) Int Cl.:
*H01L 21/208* (2006.01)

(21) Application number: **08156207.6**

(22) Date of filing: **14.05.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **16.05.2007 US 749419**

(71) Applicant: **Xerox Corporation**
**Rochester,**
**New York 14644 (US)**

(72) Inventors:
• **Li, Yuning**
 **Mississauga L5B 3K5 (CA)**
• **Ong, Beng S.**
 **609777, Singapore (SG)**

(74) Representative: **Jones, Helen M.M.**
 **Gill Jennings & Every LLP**
 **Broadgate House**
 **7 Eldon Street**
 **London EC2M 7LH (GB)**

(54) **Semiconductor Layer for Thin Film Transistors**

(57) A method for making a zinc oxide semiconductor layer for a thin film transistor using solution processing at low temperatures is disclosed. The method comprises making a solution comprising a zinc salt and a complexing agent; applying the solution to a substrate; and heating the solution to form a semiconductor layer on the substrate. A thin film transistor using this zinc oxide semiconductor layer has good mobility and on/off ratio.

EP 1 993 122 A2

## Description

The present disclosure relates to methods of making a zinc oxide semiconductor layer for a thin film transistor and the semiconductor layer and/or thin film transistor produced thereby.

Zinc oxide (ZnO) is a non-toxic inorganic semiconductor which may also offer such salient features as high mobility, excellent environmental stability and high transparency.

However, the method by which the semiconductor is fabricated will affect the mobility of the ZnO semiconductor layer. A ZnO semiconductor having high mobility is generally made only through radio-frequency magnetron sputtering. ZnO thin-film semiconductors prepared by radio frequency magnetron sputtering in delicately controlled environments have showed high FET mobility (>30 cm$^2$/V·sec), but this technique is not compatible with low-cost TFT manufacturing processes. Such equipment is expensive and leads to high production costs.

In another approach described in U.S. Patent Application Serial No. 11/450,998, filed June 12, 2006, ZnO precursors were used to form a ZnO semiconductor layer. However, this approach requires an annealing step at a temperature of 350-550°C to achieve high mobility. Such temperatures are not suitable for supports which deform at these temperatures, like polymeric supports, such as for example polyester, polycarbonate, polyimide films or sheets.

ZnO semiconductors have also been made at low (ambient) temperatures using ZnO nanoparticles or nanorods in solution. However, this approach involved an additional step to prepare the nanoparticles or nanorods. See B. Sun et al., "Solution-Processed Zinc Oxide Field-Effect Transistors Based on Self-Assembly of Colloidal Nanorods," Nano Lett., Vol. 5, No. 12, pp. 2408-2413 (2005).

TFTs are generally composed of, on a support, an electrically conductive gate, source and drain electrodes, an electrically insulating gate dielectric layer which separated the gate electrode from the source and drain electrodes, and a semiconducting layer which is in contact with the gate dielectric layer and bridges the source and drain electrodes. It would be beneficial to produce a zinc oxide semiconductor at low temperatures having good mobility and/or other desirable properties.

The present disclosure relates, in various embodiments, to a method for producing a ZnO semiconductor layer and/or a thin film transistor comprising the same.

In one embodiment, the method of making a zinc oxide semiconductor comprises providing a solution comprising a zinc salt and a complexing agent; contacting a substrate with the solution; and heating the solution to form a zinc oxide semiconductor layer.

In some embodiments, the zinc salt may be selected from the group consisting of zinc nitrate, zinc chloride, zinc sulfate, and zinc acetate. In more specific embodiments, the zinc salt is zinc nitrate.

In other embodiments, the complexing agent may be a carboxylic acid or an organoamine. In specific embodiments, the complexing agent is an organoamine selected from the group consisting of hexamethylenetetramine, ethanolamine, aminopropanol, diethanolamine, 2-methylaminoethanol, N,N-dimethylaminoethanol, methoxyethylamine, methoxypropylamine, diaminoethane, diaminopropane, diaminobutane, diaminocyclohexane, and mixtures thereof. In more specific embodiments, the complexing agent is hexamethylenetetramine.

In further embodiments, the molar ratio of zinc salt to complexing agent in the solution may be from about 0.5 to about 10.

In other embodiments, the concentration of Zn$^{2+}$ in the solution may be from about 0.01 M to about 5.0M.

In other embodiments, the substrate may be contacted with the solution comprising the zinc salt and the complexing agent by submerging the substrate therein. In additional embodiments, the substrate may also be contacted with the solution by depositing the solution thereupon. In still further embodiments, the method of liquid deposition may be selected from the group consisting of spin coating, blade coating, rod coating, dip coating, screen printing, microcontact printing, ink jet printing, and stamping.

In additional embodiments, the heating may be performed by heating comprising the zinc salt and the complexing agent to a temperature of from about 50°C to about 300°C. In other embodiments, the heating may also be performed by heating to a temperature of from about 50°C to about 150°C. In some embodiments, the solution may be heated for a period of from about 1 minute to about 24 hours. In some embodiments, the solution is heated for a period of from about 1 minute to about 6 hours, preferably from 1 minute to 200 minutes. In further embodiments, the heating may be performed by heating at a rate of from about 0.5°C to about 100°C per minute.

The method may further comprise rinsing and drying the substrate.

In some embodiments, the resulting thin film transistor may have a field effect mobility of at least 0.1 cm$^2$/V·sec, preferably at least 0.5 cm$^2$/ V·sec.

In other embodiments, the resulting semiconductor layer may have a current on/off ratio greater than about 10$^3$.

In further embodiments, the substrate may comprise a film or sheet of glass, silicon, or polymeric material.

In other embodiments, a method of making a zinc oxide semiconductor layer for a thin film transistor is provided. The method comprises providing a solution comprising zinc nitrate and hexamethylenetetramine, wherein the ratio of zinc concentration to hexamethylenetetramine concentration in the aqueous solution is from about 0.5 to about 10; submerging a substrate in the solution; and heating the aqueous solution at a rate of from about 0.5°C/min to about 10.0°C/min to a temperature of from about 50°C to about 100°C to form a zinc oxide semiconductor layer.

In additional embodiments, the support may have a deformation temperature below 300°C. In some embodiments, the support can be a polymeric support, such as for example polyester, polycarbonate, polyimide films or sheets.

In still further embodiments, the semiconductor of the TFT of the present disclosure has a mobility of at least 1 cm$^2$/V·sec. In other embodiments, the TFT has a mobility of at least 5 cm$^2$/V·sec.

The semiconductor layers or TFTs made using the processes are also disclosed.

These and other non-limiting characteristics of the disclosure are more particularly disclosed below.

The following is a brief description of the drawings.

FIG. 1 is a first exemplary embodiment of a TFT of the present disclosure.

FIG. 2 is a second exemplary embodiment of a TFT of the present disclosure.

FIG. 3 is a third exemplary embodiment of a TFT of the present disclosure.

FIG. 4 is a fourth exemplary embodiment of a TFT of the present disclosure.

A more complete understanding of the components, processes, and devices disclosed herein can be obtained by reference to the accompanying figures. These figures are merely schematic representations based on convenience and the ease of demonstrating the present development and are, therefore, not intended to indicate relative size and dimensions of the devices or components thereof and/or to define or limit the scope of the exemplary embodiments.

Although specific terms are used in the following description for the sake of clarity, these terms are intended to refer only to the particular structure of the embodiments selected for illustration in the drawings and are not intended to define or limit the scope of the disclosure. In the drawings and the following description below, it is to be understood that like numeric designations refer to components of like function.

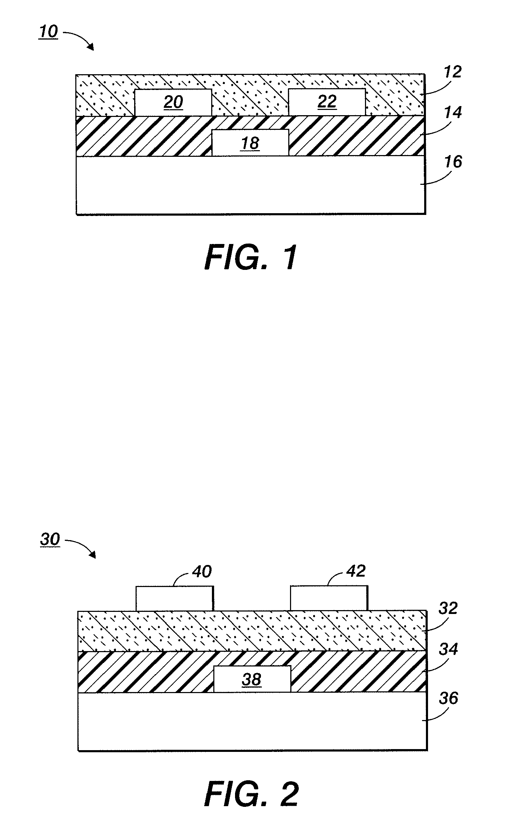

In FIG. 1, there is schematically illustrated an TFT configuration 10 comprised of a support 16, in contact therewith a metal contact 18 (gate electrode) and a layer of a gate dielectric layer 14 on top of which two metal contacts, source electrode 20 and drain electrode 22, are deposited. Over and between the metal contacts 20 and 22 is a zinc oxide semiconductor layer 12 as illustrated herein.

FIG. 2 schematically illustrates another TFT configuration 30 comprised of a support 36, a gate electrode 38, a source electrode 40 and a drain electrode 42, a gate dielectric layer 34, and a zinc oxide semiconductor layer 32.

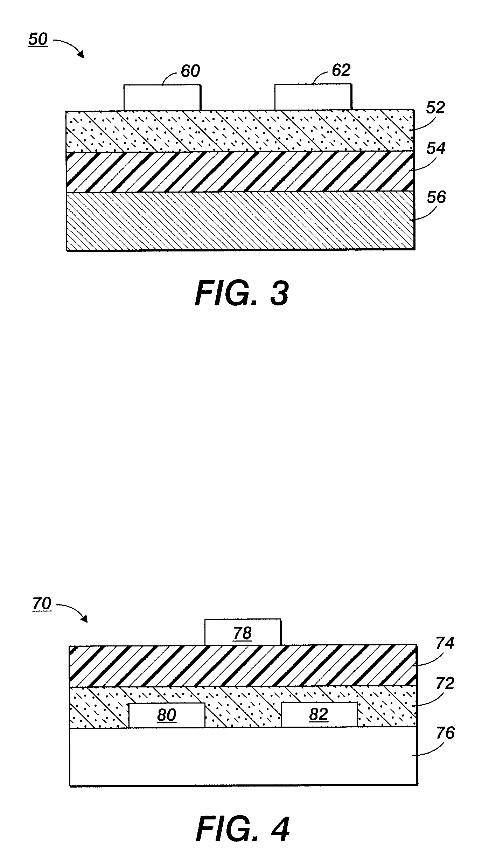

FIG. 3 schematically illustrates a further TFT configuration 50 comprised of support (not shown)/indium-tin oxide (ITO)/an aluminum-titanium oxide (ATO), wherein the ITO 56 is a gate electrode, and ATO 54 is a dielectric layer, and a zinc oxide semiconductor layer 52, on top of which are deposited a source electrode 60 and a drain electrode 62.

FIG. 4 schematically illustrates an additional TFT configuration 70 comprised of support 76, a gate electrode 78, a source electrode 80, a drain electrode 82, a zinc oxide semiconductor layer 72, and a gate dielectric layer 74.

The semiconductor of the TFT of the present disclosure has a mobility of at least 1 cm$^2$/V·sec.

The zinc oxide semiconductor layer is made by a solution processing technique. The technique comprises making a solution of a zinc salt and a complexing agent. The solution is placed in contact with a substrate and heated to form a zinc oxide layer.

In one embodiment, the zinc salt is zinc nitrate. Zinc nitrate has the chemical formula $Zn(NO_3)_2$. In other embodiments, alternative zinc salts such as zinc chloride, zinc bromide, zinc oxalate, zinc acetylacetonate, zinc sulfate, zinc acetate, and their hydrates can be used.

The complexing agent is added to facilitate the formation of a ZnO thin film and to increase the viscosity of the solution to improve thin film uniformity. The complexing agent may be, for example, a carboxylic acid or an organoamine. In embodiments, the complexing agent can be an organoamine selected for example from the group consisting of hexamethylenetetramine, ethanolamine, aminopropanol, diethanolamine, 2-methylaminoethanol, N,N-dimethylaminoethanol, methoxyethylamine, methoxypropylamine, diaminoethane, diaminopropane, diaminobutane, diaminocyclohexane, and the like, and mixtures thereof. In one embodiment, the complexing agent is hexamethylenetetramine. Hexamethylenetetramine has the chemical formula $(CH_2)_6N_4$ and is also known as hexamine, urotropine, or 1,3,5,7-tetraazaadamantane.

The substrate and solution comprising a zinc salt and a complexing agent can be contacted by submerging the substrate in the solution or by depositing the solution upon the substrate. The substrate comprises the support and any other layers or components of the TFT already deposited upon the support prior to being contacted with the solution.

Crystalline ZnO species are gradually deposited from the solution comprising a zinc salt and a complexing agent on the substrate to form the desired ZnO semiconductor layer. Several parameters of the solution can be optimized. The molar ratio of salt to complexing agent in the solution is from about 0.5 to about 10. The concentration of zinc ($[Zn^{2+}]$) may be from about 0.01 M to about 5.0M. In further embodiments, the concentration of zinc ($[Zn^{2+}]$) may be from about 0.05M to about 0.1 M. The solution may have a beginning temperature around room temperature (i.e., about 25°C).

Any suitable liquid(s) including, for instance, organic solvents and water can be used as the solvent for the solution. Suitable organic solvents include hydrocarbon solvents such as pentane, hexane, cyclohexane, heptane, octane, nonane, decane, undecane, dodecane, tridecane, tetradecane, toluene, xylene, mesitylene, and the like; alcohols such as methanol, ethanol, propanol, butanol, pentanol, hexyl alcohol, heptyl alcohol, ethyleneglycol, methoxyethanol, ethoxyethanol, methoxypropanol, ethoxypropanol, methoxybutanol, dimethoxyglycol, and the like, ketones such as acetone, butanone, pentanone, cyclohexanone, and the like, tetrahydrofuran, chlorobenzene, dichlorobenzene, trichlorobenzene, nitrobenzene, cyanobenzene, acetonitrile, N,N-dimethylformamide, and mixtures thereof.

In embodiments, other components can be incorporated in the solution to be incorporated into the semiconductor layer. Such components include, for example, a polymer such as polystyrene, poly(methylmethacrylate, poly(vinylpyrollidone), and the like, metal nanoparticles of such as gold, silver, and the like, metal oxide nanoparticles of such as silicon oxide, gallium oxide, zirconium oxide, aluminum oxide, tin oxide, indium-tin oxide (ITO), and the like, and mixtures thereof.

Liquid processing techniques include submerging the substrate into the solution comprising the zinc salt and the complexing agent or liquid depositing the solution comprising the zinc salt and the complexing agent onto the substrate. Liquid depositing the solution onto the substrate can be accomplished by any liquid deposition techniques such as for instance spin coating, blade coating, rod coating, dip coating, screen printing, microcontact printing, ink jet printing, stamping and the like.

Heating refers to a heat treatment of the solution comprising the zinc salt and complexing agent at a temperature or several temperatures within a range of between about 50°C and about 300°C. The heating can be accomplished, for example, in an instant heating manner at a certain temperature using a pre-heated solution comprising the zinc salt and complexing agent. In embodiments, the heating can be accomplished in a gradual heating manner with a heating rate that the heating equipment can achieve, ranging from about 0.5 to about 100°C per minute (°C/min). The heating step may begin at room temperature (about 25°C) or at a temperature from about 25°C to about 100°C. In further embodiments, the heating can also be accomplished step-wise at several temperatures, such as, for example, at about 100°C, then at about 200°C, and then at about 300°C. In embodiments, the heating can also be accomplished step-wise at several temperatures, combined with gradual heating. The heating can also be accomplished for instance at a higher temperature and then at a lower temperature such as first at about 300°C and then at about 200°C. In some specific embodiments, all heating is done at temperatures below about 100°C. In a specific embodiment, the heating is performed by heating at a rate of 1°C/min. In a specific embodiment, the heating is performed by heating at a rate of about 1 °C/min up to a temperature of about 90°C. The solution may be heated for a period of from about 1 minute to about 24 hours. Generally, the solution and the substrate are heated together.

The process may further comprise a cooling phase. "Cooling" refers to bringing the temperature of the solution comprising the zinc salt and complexing agent from the final temperature of the heating, and particularly down to about room temperature. The cooling can be accomplished for instance in a self-cooling manner by turning off the heating equipment or in a controlled manner at a certain cooling rate such as for example from about 0.1 °C/min to about 100°C/min. In embodiments, a slow cooling rate of about 0.1°C/min to about 10°C/min may be employed, especially from a temperature higher than about 200°C, to reduce mechanical strain in the semiconductor layer(s) and the substrate.

The process may further comprise a cleaning phase. "Cleaning" refers to cleaning the substrate comprising the ZnO thin films after the cooling step in order to remove unreacted zinc salt, complexing agent, precipitates, and/or solvent on the surface of the ZnO thin film. Any suitable liquid(s) including, for instance, organic solvents and water can be used for rinsing. Suitable organic solvents include hydrocarbon solvents such as pentane, hexane, cyclohexane, heptane, octane, nonane, decane, undecane, dodecane, tridecane, tetradecane, toluene, xylene, mesitylene, and the like; alcohols such as methanol, ethanol, propanol, butanol, pentanol, hexyl alcohol, heptyl alcohol, ethyleneglycol, methoxyethanol, ethoxyethanol, methoxypropanol, ethoxypropanol, methoxybutanol, dimethoxyglycol, and the like, ketones such as acetone, butanone, pentanone, cyclohexanone, and the like, tetrahydrofuran, chlorobenzene, dichlorobenzene, trichlorobenzene, nitrobenzene, cyanobenzene, acetonitrile, N,N-dimethylformamide, and mixtures thereof. Cleaning can be carried out in any manner such as, for example, by washing the substrate comprising ZnO thin film with a solvent or by dipping the substrate comprising ZnO thin film into a solvent. Cleaning can be carried out at temperatures from about room temperature (25°C) to about 300 °C, but generally is done at room temperature. Ultrasonic cleaning equipment can be optionally used to facilitate the cleaning.

The process may further comprise a drying phase. "Drying" refers to removing any remaining liquid from the surface of the ZnO thin film after the cleaning step, with or without the heating step. In specific embodiments, the drying phase is performed at temperatures of from 100°C to about 150°C for period of from about 1 to about 120 minutes.

The zinc oxide semiconductor layer of the present disclosure can be used in electronic devices such as large area displays, radio-frequency identification (RFID) tags, etc. which use thin film transistors with high field-effect mobility of, for example, about 0.1 cm$^2$/V·s.

The zinc oxide semiconductor layer has a thickness ranging from about 10 nanometers to about 1 micrometer, particularly a thickness of from about 20 nanometers to about 200 nanometers. The TFT devices contain a semiconductor channel with a width, W and length, L. The semiconductor channel width may be, for example, from about 0.1 micrometers to about 5 millimeters, with a specific channel width being about 5 micrometers to about 1 millimeter. The semiconductor channel length may be from about 0.1 micrometer to about 1 millimeter with a more specific channel length being from about 5 micrometers to about 100 micrometers.

The support may be composed of any suitable materials, for instance silicon, glass, aluminum, or plastics. The thickness of the support may be from about 10 micrometers to over 10 millimeters with a representative thickness being from about 1 to about 10 millimeters for a rigid support such as glass plate or silicon wafer. In particular, the processes of the present disclosure allow the use of supports which may have a melting or softening temperature near or below about 300°C.

The gate electrode can be a thin metal film, a conducting polymer film, a conducting film made from conducting ink or paste or the support itself, for example heavily doped silicon. Examples of gate electrode materials include but are not restricted to aluminum, nickel, gold, silver, copper, zinc, indium, zinc-gallium oxide, indium tin oxide, indium-antimony oxide, conducting polymers such as polystyrene sulfonate-doped poly(3,4-ethylenedioxythiophene) (PSS-PEDOT), conducting ink/paste comprised of carbon black/graphite or colloidal silver dispersion in polymer binders, such as ELECTRODAG™ available from Acheson Colloids Company. The gate electrode can be prepared by vacuum evaporation, sputtering of metals or conductive metal oxides, coating from conducting polymer solutions or conducting inks by spin coating, casting or printing. The thickness of the gate electrode ranges for example from about 10 to about 200 nanometers for metal films and in the range of about 1 to about 10 micrometers for polymer conductors. Typical materials suitable for use as source and drain electrodes include those of the gate electrode materials such as aluminum, zinc, indium, conductive metal oxides such as zinc-gallium oxide, indium tin oxide, indium-antimony oxide, conducting polymers and conducting inks. Typical thicknesses of source and drain electrodes are about, for example, from about 40 nanometers to about 1 micrometer with the more specific thickness being about 100 to about 400 nanometers.

The gate dielectric layer generally can be an inorganic material film or an organic polymer film. Illustrative examples of inorganic materials suitable as the gate dielectric layer include aluminum-titanium oxide, aluminum oxide, silicon oxide, silicon nitride, barium titanate, barium zirconium titanate and the like; illustrative examples of organic polymers for the gate dielectric layer include polyesters, polycarbonates, poly(vinyl phenol), polyimides, polystyrene, poly(methacrylate)s, poly(acrylate)s, epoxy resin and the like. The thickness of the gate dielectric layer is, for example from about 10 nanometers to about 2000 nanometers depending on the dielectric constant of the dielectric material used. An representative thickness of the gate dielectric layer is from about 100 nanometers to about 500 nanometers. The gate dielectric layer may have a conductivity that is for example less than about $10^{-12}$ S/cm.

In embodiments, the gate dielectric layer, the gate electrode, the semiconductor layer, the source electrode, and the drain electrode are formed in any sequence with the gate electrode and the semiconductor layer both contacting the gate dielectric layer, and the source electrode and the drain electrode both contacting the semiconductor layer. The phrase "in any sequence" includes sequential and simultaneous formation. For example, the source electrode and the drain electrode can be formed simultaneously or sequentially.

The dielectric layer or the support upon which the semiconductor layer is deposited may contain or be surface-modified to contain surface polar functional groups, such as -OH, $-NH_2$, -COOH, $-SO_3H$, $-P(=O)(OH)_2$, etc. It has been found that certain crystalline ZnO species will strongly interact with the surface polar functional groups such that they are strongly attached to the dielectric layer or the support.

The "substrate" refers to a support or a support comprising dielectric layer and/or electrode(s) (gate, source, and/or drain) such as, for example, a support with a dielectric layer, a support with gate electrode and dielectric layer, or a support with source and drain electrodes, or a support with a dielectric layer and source and drain electrodes, excluding a semiconductor layer.

For a n-channel TFT, the source electrode is grounded and a bias voltage of generally, for example, about 0 volt to about 80 volts is applied to the drain electrode to collect the charge carriers transported across the semiconductor channel when a voltage of generally about -20 volts to about +80 volts is applied to the gate electrode.

In embodiments, the zinc oxide semiconductor layer in a TFT device generally exhibits a field-effect mobility of greater than for example about 1 $cm^2$/Vs (square centimeter per Volt per second), and an on/off ratio of greater than for example about $10^3$. On/off ratio refers to the ratio of the source-drain current when the transistor is on to the source-drain current when the transistor is off.

It will be appreciated that various of the above-disclosed and other features and functions, or alternatives thereof, may be desirably combined into many other different systems or applications. Various presently unforeseen or unanticipated alternatives, modifications, variations or improvements therein may be subsequently made by those skilled in the art which are also intended to be encompassed by the following claims. Unless specifically recited in a claim, steps or components of claims should not be implied or imported from the specification or any other claims as to any particular order, number, position, size, shape, angle, color, or material.

The processes of the present disclosure are illustrated in the following non-limiting example.

## EXAMPLE

A glass support (-2x2 cm) coated with a - 260 nm sputtered indium tin oxide (ITO) layer and a - 180 nm layer of $Al_2O_3$ and $TiO_2$ (ATO; Ci = 70 nF/cm$^2$) was used. The glass acted as a support material, the ITO acted as a gate electrode, and the ATO acted as a dielectric layer. The substrates were cleaned by argon plasma and then submerged in a vessel containing an aqueous solution of zinc nitrate and hexamethylenetetramine having a molar ratio of $Zn^{2+}$ to hexamethylenetetramine of 1:1 and a zinc concentration ($[Zn^{2+}]$) of about 0.1 M at room temperature. The vessel was then heated to 90°C at a rate of about 1°C/min. After the reaction temperature reached 90°C, the vessel was cooled to room temperature. The substrates were then cleaned ultrasonically for 5 minutes in distilled water to remove any precipitate attached to the surface of the deposited films. The substrates were then dried at 25°C for one hour and at 150°C for 30 minutes on a hot plate. Finally, an array of aluminum source-drain electrode pairs with channel lengths of 90 microns and channel widths of 5000 microns were evaporated on top of the ZnO layer to form ZnO TFTs similar to FIG. 3.

TFT performance was evaluated using a Keithley 4200 SCS semiconductor characterization system. The saturated carrier mobility, $\mu$, was calculated according to the equation:

$$I_{SD} = C_i\mu \ (W/2L) \ (V_G\text{-}V_T)$$

where $I_{SD}$ is the drain current at the saturated regime; W and L are the channel width and length; $C_i$ is the capacitance per unit area of the dielectric layer; and $V_G$ and $V_T$ are the gate voltage and threshold voltage, respectively. The transfer and output characteristics of the devices showed that ZnO was an n-type semiconductor. Using several TFTs with dimensions of L=90 microns and W=5,000 microns, an average mobility of 1.0 cm$^2$/V·s and current on/off ratio of 10$^4$ were obtained.

**Claims**

1. A method of making a zinc oxide semiconductor layer for a thin film transistor, comprising:

   providing a solution comprising a zinc salt and a complexing agent;
   contacting a substrate with the solution; and
   heating the solution to form a zinc oxide semiconductor layer on the substrate.

2. The method of claim 1, wherein the zinc salt is selected from the group consisting of zinc nitrate, zinc chloride, zinc bromide, zinc oxalate, zinc acetylacetonate, zinc sulfate, zinc acetate, and their hydrates.

3. The method of any preceding claim, wherein the complexing agent is a carboxylic acid or an organoamine, wherein the organoamine is preferably selected from the group consisting of hexamethylenetetramine, ethanolamine, aminopropanol, diethanolamine, 2-methylaminoethanol, N,N-dimethylaminoethanol, methoxyethylamine, methoxypropylamine, diaminoethane, diaminopropane, diaminobutane, diaminocyclohexane, and mixtures thereof.

4. The method of any preceding claim, wherein the molar ratio of zinc salt to complexing agent in the solution is from 0.5 to 10.

5. The method of any preceding claim, wherein the concentration of $Zn^{2+}$ in the solution is from 0.01 M to 5.0 M.

6. The method of any preceding claim, wherein the substrate is contacted with the solution by submerging the substrate therein.

7. The method of any of claims 1 to 5, wherein the substrate is contacted with the solution by depositing the solution thereupon, preferably wherein the method of liquid deposition is selected from the group consisting of spin coating, blade coating, rod coating, dip coating, screen printing, microcontact printing, ink jet printing, and stamping.

8. The method of any preceding claim, wherein the heating is performed by heating to a temperature of from 50°C to 300°C, preferably from 50°C to 150°C.

9. The method of any preceding claim, wherein the solution is heated for a period of from 1 minute to 24 hours, preferably from 1 minute to 6 hours, most preferably from 1 minute to 200 minutes.

10. The method of any preceding claim, wherein the heating is performed by heating at a rate of from 0.5°C to 100°C per minute.

11. The method of any preceding claim, further comprising cleaning and drying the substrate.

12. The method of any preceding claim, wherein the substrate comprises a film or sheet of glass, silicon, or polymeric material.

13. A thin film transistor having the feature of a zinc oxide semiconductor layer formed by the method of any of claims 1 to 12.

**14.** The thin film transistor of claim 13, wherein the thin film transistor has a field effect mobility of at least $0.1 \text{ cm}^2/\text{V·sec}$, preferably at least $0.5 \text{ cm}^2/\text{V·sec}$.

**15.** The thin film transistor of claim 13 or 14, wherein the semiconductor layer has a current on/off ratio greater than about $10^3$.

**FIG. 1**

**FIG. 2**

50

60          62

52

54

56

**FIG. 3**

70

78          74

72

80      82

76

**FIG. 4**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 45099806 A

**Non-patent literature cited in the description**

- **B. SUN et al.** Solution-Processed Zinc Oxide Field-Effect Transistors Based on Self-Assembly of Colloidal Nanorods. *Nano Lett.,* 2005, vol. 5 (12), 2408-2413